Europäisches Patentamt

(19) European Patent Office

Office européen des brevets

(11) Publication number: **0 006 702**
**B1**

(12) **EUROPEAN PATENT SPECIFICATION**

(45) Date of publication of patent specification: **27.01.82**

(51) Int. Cl.³: **H 01 L 27/02, G 11 C 11/40**

(21) Application number: **79301092.7**

(22) Date of filing: **08.06.79**

(54) Semiconductor integrated memory circuit.

(30) Priority: **14.06.78 JP 71666/78**

(43) Date of publication of application:
**09.01.80 Bulletin 80/1**

(45) Publication of the grant of the European patent:
**27.01.82 Bulletin 82/4**

(84) Designated Contracting States:
**DE GB NL**

(56) References cited:
**FR - A - 2 338 546**
**US - A - 3 815 106**

**IBM TECHNICAL DISCLOSURE BULLETIN, vol.
18, March 1976, New York
M. A. BATTISTA et al. "Lateral pnp structure for
memory cell" pages 3254—3255**

(73) Proprietor: **Nippon Telegraph and Telephone
Public Corporation
1-6 Uchisaiwai-cho, 1-chome Chiyoda-ku
Tokyo 100 (JP)**

(73) Proprietor: **FUJITSU LIMITED
1015, Kamikodanaka Nakahara-ku
Kawasaki-shi Kanagawa 211 (JP)**

(72) Inventor: **Suzuki, Masao
890, Minami-cho Hanakoganei Kodaira-shi
Tokyo 187 (JP)**
Inventor: **Hayashi, Toshio
2416-1, Hanazono 2-chome
Tokorozawa-shi Saitama 359 (JP)**
Inventor: **Kawarada, Kuniyasu
30-5, Kita-machi 1-chome
Kichijyoji Masashino-shi Tokyo 180 (JP)**
Inventor: **Toyoda, Kazuhiro
39-1433 Sakuradai, Midori-ku
Yokohama-shi Kanagawa 227 (JP)**
Inventor: **Ono, Chikai
322, Seki, Tama-ku Kawasaki-shi
Kanagawa 214 (JP)**

(74) Representative: **Rackham, Stephen Neil et al,
GILL JENNINGS & EVERY
53/64 Chancery Lane London WC2A 1HN (GB)**

Semiconductor impregnated memory circuit

The present invention relates to an improvement in a semiconductor integrated circuit memory device in which memory cells formed by integrated injection logic are arranged in an array.

In conventional memory cells used in a semiconductor memory, resistors are used as load impedances of flip-flop transistors used in the memory cells, and also, an insulation between transistors is required, so that the conventional memory cells are large in size. Therefore, a memory chip is also large in size and the packing density of the memory cells which are included in one wafer can not be increased, so that the cost of a bit of semiconductor memory is relatively expensive.

For the purpose of obtaining memory cells of smaller dimensions, memory cells using integrated injection logic are used.

At present, memory cells formed by integrated injection logic are a considerable advance because such memory cells can be formed with high packing density. Such memory cells are disclosed, for example, in the articles "Write Current Control and Self Powering in a Low Power Memory Cell," IEEE, SCC, Jun., 1973, and "Superintegrated Memory Shares Functions on Diffused Islands," Electronics February 14, 1972, p83—p86. The former discloses a method of controlling a write current to an integrated injection logic memory cell and the latter discloses the basic idea of an integrated injection logic memory cell.

As disclosed in the above mentioned articles, and in United States of America Patent Specification No 3815106, the integrated injection logic memory cell comprises a pair of first and second transistors which have a common emitter forming an injector which is connected to a word line W+, first and second transistors of a first conduction type, a pair of third and fourth transistors of second conduction type each of which has its collector connected to the collector of the first and the second transistors, respectively, the base of the third transistor being connected to the collector of the fourth transistor and the base of the fourth transistor being connected to the collector of the third transistor, and a bulk which includes a buried layer forming a second word line W— which is connected to the bases of the first and second transistors and to the emitters of the third and fourth transistors.

The integrated injection logic memory cells are arranged in an array with each line of the array having a common word line. In these integrated injection logic memory cell arrays, the word line W— is formed as a buried layer in the bulk, with the bulk usually consisting of two n-type layers, an epitaxial layer and the buried layer. The epitaxial layer is formed on the buried layer which has higher density of the impurity than the epitaxial layer. Therefore, the word line W— has a larger resistance than a metal wire, and this resistance exists between each cell in the array.

When the bulk is used as the word line W—, which supplies the hold current, the characteristics of the individual cells differ in accordance with their position along the word line. In the conventional integrated injection logic memory, a hold current source is provided at only one end of a word line containing a number of cells. Therefore, injection currents which are supplied to the cells vary with their position along the word line so that a uniform distribution of the injection currents to the memory cells can not be obtained. Therefore, the memory cell arranged near the end of the path has an increased write threshold current Iwth and, also, has an increased width of the write pulse.

According to this invention a semiconductor integrated circuit device of the above kind has two current sources, one of the current sources being connected to one end of the second word line and the other of the current sources being connected to the other end of the second word line.

Various embodiments of semiconductor devices in accordance with this invention will now be described and contrasted with earlier proposals with reference to the accompanying drawings, in which:—

Figure 1A, 1B and 1C illustrate the equivalent circuits of integrated injection logic memory cells;

Figure 2 illustrates a cross section through a memory array formed by the integrated injection logic memory cell;

Figure 3 is a circuit diagram of a conventional array forming n bits of memory using the integrated injection logic memory cells which include a hold circuit at one end of the array;

Figure 4A illustrates an equivalent circuit of the array shown in Figure 3, and Figure 4B is a diagram illustrating the distribution of injection currents in such a memory array;

Figure 5 is a circuit diagram of a first embodiment of the present invention;

Figure 6 is a graph illustrating the distribution of injection currents of the memory cells in the first embodiment;

Figure 7A and 7B are a plan and a section respectively, of the first embodiment;

Figure 8 is a circuit diagram of a second embodiment of the present invention;

Figure 9 is a graph illustrating a distribution of injection currents of the memory cells in the second embodiment;

Figures 10A and 10B are a plan and a section, respectively, of the second embodiment;

Figure 11A is a graph illustrating the variation of the distribution of the injection currents of the memory cells in the second embodiment when the ratio of the hold currents is changed; and, Figure 11B is an equivalent circuit of the second embodiment.

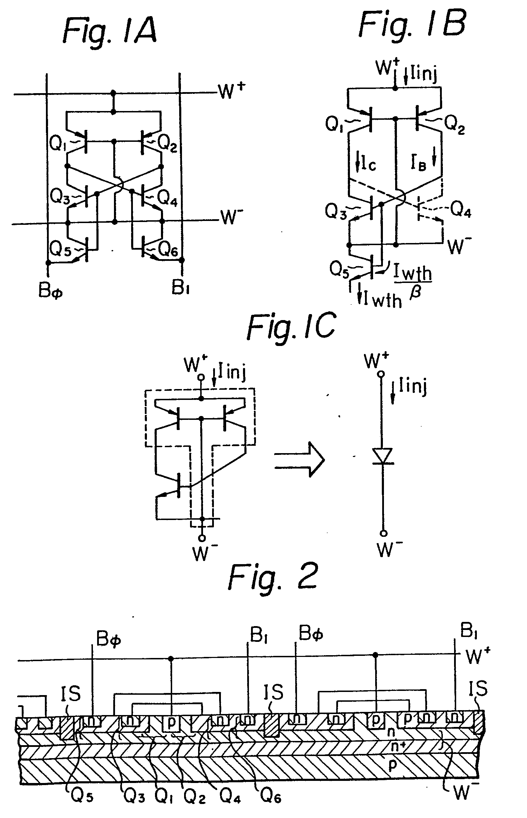

Figure 1A is an illustration of an equivalent circuit corresponding to one memory cell which is formed by integrated injection logic. In Figure 1A, $Q_1$ to $Q_6$ designate transistors, W+ and W— designate word lines, and $B_1$ and $B_\phi$ designate bit lines, respectively. Figure 2 illustrates a cross section through the memory cell array formed by the integrated memory cells illustrated in Figure 1. In Figure 2, symbols which are the same as in Figure 1 designate corresponding parts to those illustrated in Figure 1.

Referring to Figures 1A and 2, a p type conduction region which is connected to the word line W+ is an injector, and the p type conduction region is actuated as common emitters of lateral pnp transistors $Q_1$, $Q_2$. This will be understood when Figure 2 is compared with Figure 1A. As illustrated in Figures 1A and 2, the transistors $Q_1$ and $Q_2$ are used as loads, the usual collector regions of npn transistors $Q_3$ and $Q_4$ which are connected to a word line W— are used as emitters, and the usual emitter regions of npn transistors $Q_3$ and $Q_4$ are used as collectors. Therefore, a bulk, that is, an n-type conduction region, which is commonly used as the bases of the pnp transistors $Q_1$ and $Q_2$, and as the emitters of the npn transistors $Q_3$ and $Q_4$, can be used as a buried word line W—, so that the cells can be formed in a high density. Each cell is isolated by an isolation boundary region IS.

Referring to the memory cell illustrated in Fig. 1A, transistors $Q_3$ and $Q_4$ are placed in the on and off state alternately. That is, for example, when the transistor $Q_3$ is placed in the on state, the transistor $Q_4$ is placed in the off state. Fig. 1B illustrates an equivalent circuit of Fig. 1A when the transistor $Q_3$ is placed in the on state. An injection current Iinj supplies a base current of the on state transistor $Q_3$. In order to change the cell information, the on state transistor $Q_3$ should be changed to the off state. This is done by supplying an emitter current larger than the write theshold current Iwth to the transistor $Q_5$ and by bypassing the base current of the transistor $Q_3$ to the base current

$$\frac{\text{Iwth}}{\beta}$$

of the transistor $Q_5$. As the base current of the transistor $Q_3$ depends on the injection current Iinj supplied to the injector, the write threshold current Iwth depends on the injection current Iinj. Therefore, in the conventional memory cells, the write threshold current is large in the cell where the injection current is large. Fig. 1C illustrates the fact that an equivalent circuit of a memory cell which is not selected is replaced to an equivalent diode.

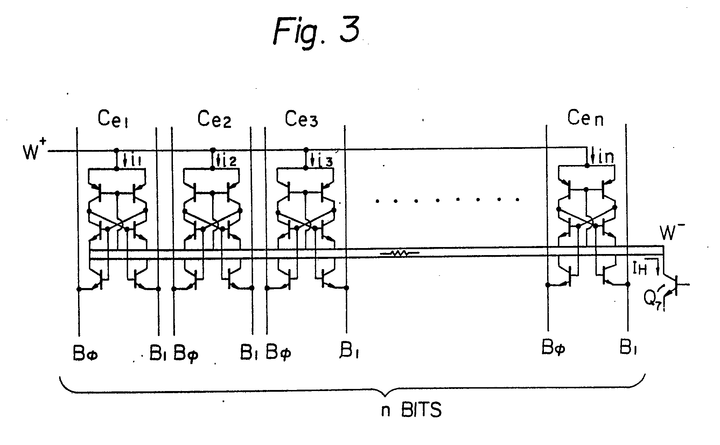

Fig. 3 illustrates an array which forms n bits by using the memory cells illustrated in Figs. 1A and 2, which array provides a hold circuit. Referring to Fig. 3, $Ce_1$, $Ce_2$, ... $Ce_n$ designate a first, a second, ... , an n'th cell, respectively. A common emitter n type conduction region of a column wire W— is used, as already mentioned, as an underpass connection. A transistor $Q_7$ is provided for supplying injection currents $i_1$, $i_2$, ... $i_n$ to the cells $Ce_1$, $Ce_2$, ... , $Ce_n$ in the array, and the transistor $Q_7$ is used as the current source for supplying the hold current $I_{H.}$. Therefore, the following equation can be established.

$$i_1 + i_2 + \ldots + i_n = I_H$$

The common emitter n type region of the word line W—, consists of two n type layers, an epitaxial layer and a buried layer. The epitaxial layer is formed on the buried layer which has higher density of the impurity than the epitaxial layer. Therefore, the word line W— has a larger resistance than a metalic layer, and this resistance is due to the bulk resistance and exists between each cell. This resistance deteriorates the characteristics of the semiconductor memory which utilizes integrated injection logic memory cells. This is due to the following reason.

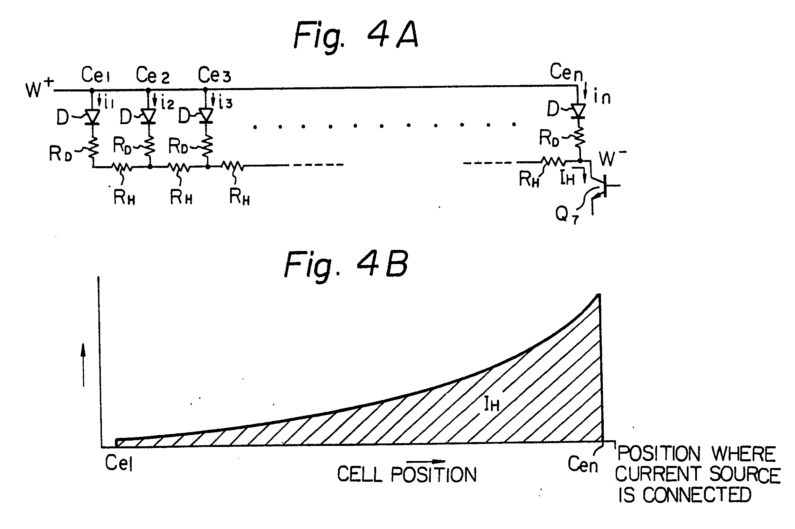

As the cells $Ce_1$, $Ce_2$, ... $Ce_n$ are illustrated as equivalent diodes which are connected between the word line W+ and the word line W—, the circuit illustrated in Fig. 3 can be illustrated as the equivalent circuit in Fig. 4A. Referring to Fig. 4A "D" designates the equivalent diode, "$R_0$" designates a series resistance which is due to the afore-mentioned n type epitaxial layer, and "$R_H$" designates a resistance component between the memory cells $Ce_1$, $Ce_2$, ... , $Ce_n$.

When the hold current $I_H$ is supplied via the transistor $Q_7$ in the circuit illustrated in Fig. 4A, the injection current supplied to each memory cell exponentially decreases from the cell $Ce_n$ to the cell $Ce_1$ as shown in Fig. 4B, due to the resistance $R_H$, which exists in the word line W— between each cell. That is, the injection current which is supplied to the cell $Ce_1$), which is at an opposite end to the transistor $Q_7$, has a minimum value.

The injection current which can assure the function of the memory cells, has a lower limit which is determined by the current amplification factor $h_{FE}$ of the transistor. Further, as it is required that all memory cells in the memory array be assured, the hold current $I_H$ in the memory array must be determined taking into the consideration the minimum injection current supplied to the memory cell $Ce_1$. Therefore, surplus injection currents must be supplied in the cell $Ce_2$, ... , $Ce_n$, and the excessive electrical power must be disipated in the memory array. Further, as the injection current to each cell is exponentially distributed, as shown in Fig. 4B, in accordance with the position of the cells, the read and write characteristics of the memory cells are also different in accordance with the position of the cells.

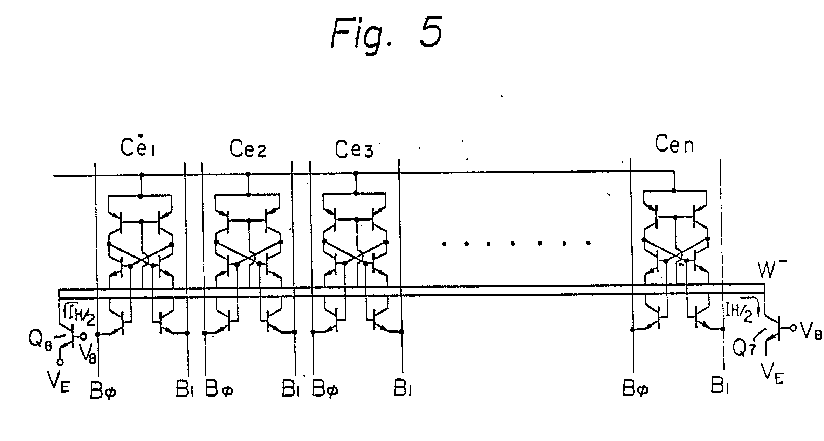

Fig. 5 illustrates a circuit of one embodiment of the present invention. The circuit illustrated in Fig. 5 is formed as an n bits array and the same symbols as used in Fig. 3 indicate the same elements as in Fig. 3.

In the circuit illustrated in Fig. 5, the transistor $Q_7$ is connected to one end of the word line W—, at $a_l$ position near the memory cell $Ce_n$, and the current

$$\frac{H}{2}$$

is supplied to the transistor $Q_7$. A transistor $Q_8$ is connected to the other end of the word line W—, at $a_l$

$$\frac{H}{2}$$

is supplied to the transistor $Q_8$. That is, in the present invention, the transistors $Q_7$ and $Q_8$ are connected respectively to each end of the word line W— and the hold current $I_H$ is equally distributed to the transistors $Q_7$ and $Q_8$.

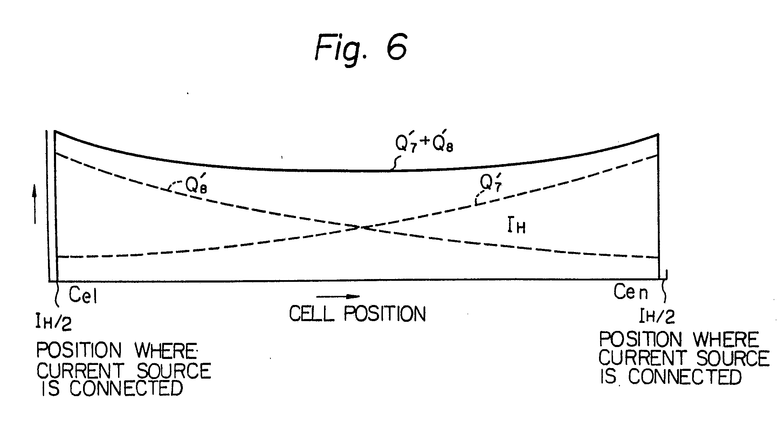

The distribution of the injection currents supplied to each cell in the circuit illustrated in Fig. 5 is shown in the diagram of Fig. 6. Referring to Fig. 6, a broken line $Q_7'$ shows the distribution of the injection currents when only the transistor $Q_7$ is provided, and the broken line $Q_8'$ shows the distribution of the injection currents when only the transistor $Q_8$ is provided. As seen from the broken lines $Q_7'$ and $Q_8'$, the value of the injection current has a maximum value at the side where the transistor is connected and the values of the injection current decrease exponentially. However, in the present invention, as the transistors $Q_7$ and $Q_8$ are respectively connected to each end of the word line W—, the distribution of the injection current which is shown by the full line $Q_7' + Q_8'$ can be obtained. That is, by the combination of the characteristics shown by the broken lines $Q_7'$ and $Q_8'$, the injection current supplied to each cell can be equalized.

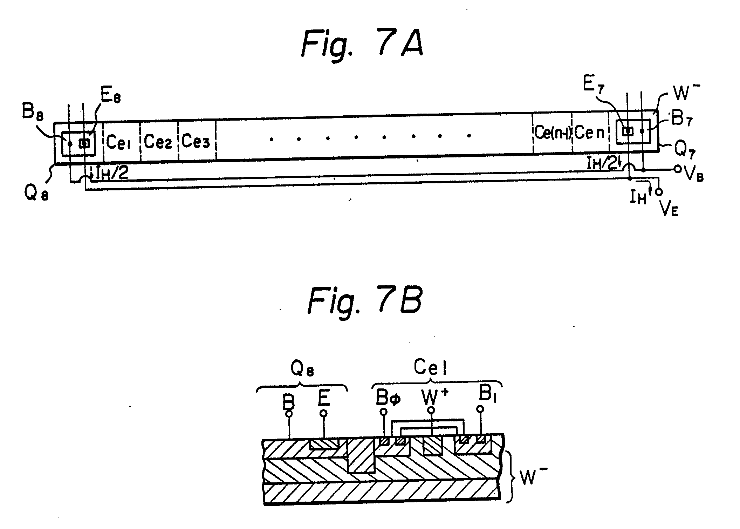

Fig. 7A is a plan view of the essential part of the circuit illustrated in Fig. 5 and Fig. 7B illustrates a cross sectional view of the circuit near the transistor $Q_8$ in Fig. 7A. In Figs. 7A and 7B, the dimensions of the word lines W+, W—, and "n" and "p" type diffusion regions are not proportional to the actual circuit.

Referring to Fig. 7A, the word line W—, that is, the common "n" type conduction region of the bulk, is commonly used in the collectors of the transistor $Q_7$ and $Q_8$. The areas of emitters $E_7$ and $E_8$ of the transistors $Q_7$ and $Q_8$ are equal and each emitter of the transistors $Q_7$ and $Q_8$ is connected via a connection wire to a terminal

$V_E$. Further, bases $B_7$ and $B_8$ of the transistors $Q_7$ and $Q_8$ are connected via a connection wire to a terminal $V_B$. When a suitable bias voltage is supplied to the terminals $V_B$ and $V_E$, so as to supply the hold current $I_H$, equal currents

$$\frac{H}{2}$$

are supplied to the transistors $Q_7$ and $Q_8$, which have an equal emitter area, so that the distribution of the injection current shown in Fig. 6 can be obtained.

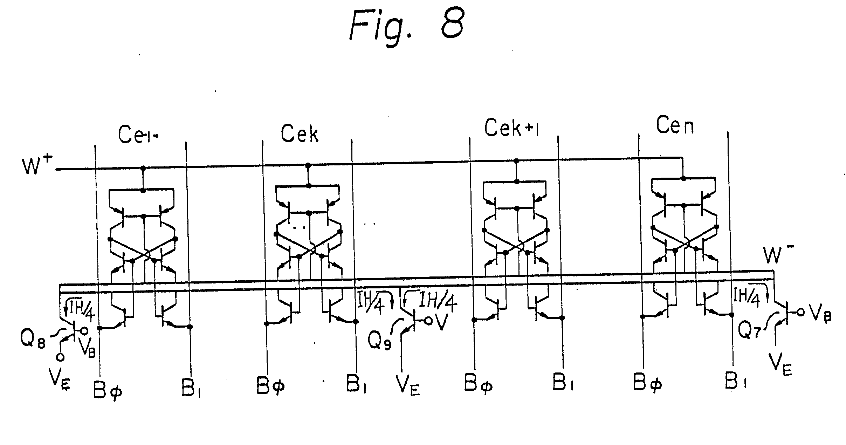

The scope of the present invention is not limited to the above-mentioned embodiment, and many modifications thereof are possible. In the above-mentioned embodiment, the "npn" type integrated injection memory is used in the memory cell, however, the present invention can be used regardless of the conduction type of the memory cell when the resistance exists in the word line (for example W—). Further, in the embodiment illustrated in Fig. 5, the transistors used as the current source are provided at both ends of the word line, however, for the purpose of more uniformly distributing, a current source can be additionally provided at the middle point of the word line, as illustrated in Figure 8.

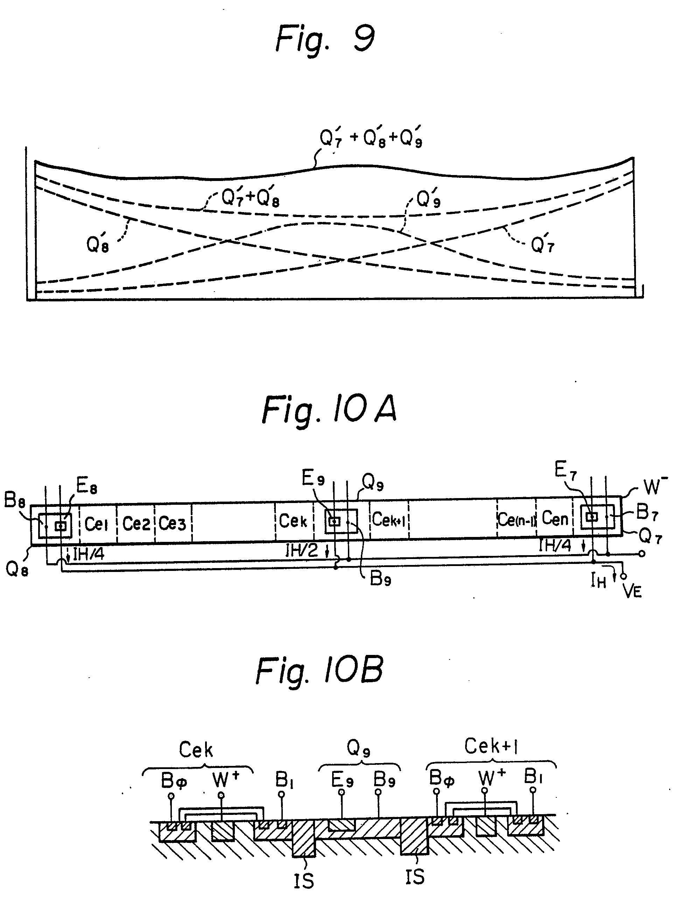

In the embodiment illustrated in Fig. 8, beside the transistors $Q_7$ and $Q_8$ of Fig. 5, having an emitter $E_9$ and a base $B_9$ is further provided at the middle point of the word line as the current source. Fig. 9 shows the distribution of the injection currents supplied to each cell in the circuit illustrated in Fig. 8. Referring to Fig. 9, curves $Q_7'$, $Q_8'$, $Q_9'$ respectively show the distribution of the injection current when only the transistor $Q_7$, $Q_8$ or $Q_9$ is provided. A curve $Q_7' + Q_8'$ shows the distribution of the injection currents when the transistors $Q_7$ and $Q_8$ are connected to both ends of the word line, and this curve $Q_7' + Q_8'$ corresponds to the full line $Q_7' + Q_8'$ shown in Fig. 6. In the embodiment illustrated in Fig. 8, as the transistor $Q_9$ is further provided at the middle point of the word line, a flatter distribution curve $Q_7' + Q_8' + Q_9'$ than that of Fig. 5 can be obtained.

Fig. 10A is a plan view of the essential part of the circuit illustrated in Fig. 8 and in Fig. 10A, the distribution ratio of the hold currents is selected to be 1:2:1. Fig. 10B is a cross sectional view of the circuit near the transistor $Q_9$ at the middle point of the word line in Fig. 10A. Figs. 10A and 10B, the dimensions of the word lines W+ and W—, and the "n" and "p" type diffusion regions is not proportional to the actual circuit.

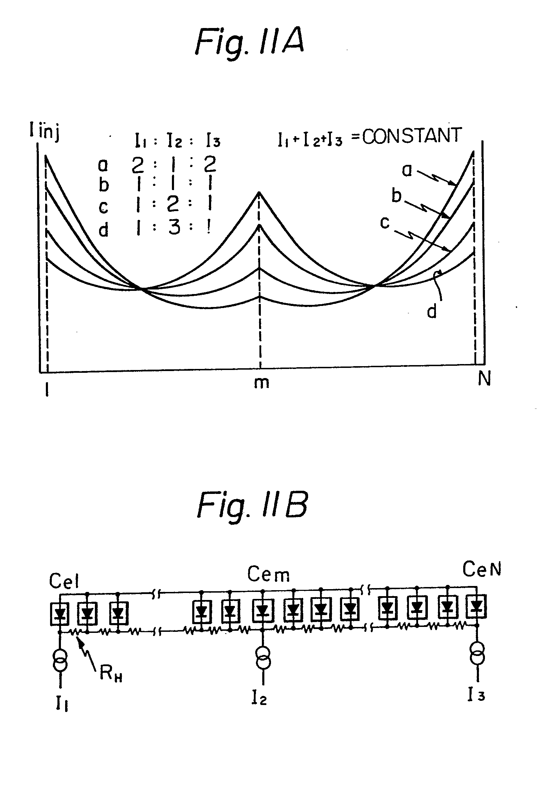

Fig. 11A shows examples of the result of the simulation of the injection current to each Cell $Ce_1$, $Ce_2$, ... , $Ce_n$ in the circuit illustrated in Fig. 8. Fig. 11A shows the variation of the distribution of the injection currents when the ratio of the hold current $I_1$, $I_2$ and $I_3$ in the equivalent circuit of Fig. 11B is changed. In Fig. 11A, the

value of the vertical axis is magnified in order to distinguish the differences between the cases. In Fig. 11A, "a" designates a curve obtained when the ratio of the hold currents is selected to be 2:1:2, "b" designates a curve obtained when the ratio of the hold currents is selected to be 1:1:1, "c" designates a curve obtained when the ratio of the hold currents is selected to be 1:2:1, and "d" designates a curve when the ratio of the hold currents is selected to be 1:3:1. In Figs. 11A and 11B, it is assumed that the sum of the hold currents $I_1$, $I_2$ and $I_3$ is constant and that the value of the resistance $R_H$ is in the range of from 20 to 100 $\Omega$. As illustrated in Fig. 11A, the flattest distribution curve of the injection currents of the cells can be obtained when the dividing ratio of the hold current $I_H$ is selected to be 1:2:1. The embodiment illustrated in Fig. 10A is based on this flattest distribution curve. Further, a flatter distribution curve can be obtained by providing further current sources and be selecting a suitable ratio of the hold currents.

As mentioned above, according to the present invention, even if a semiconductor bulk having a larger resistance than a metalic wire is used as the word line the distribution of the injection currents to each cell can be equalized by providing current sources at both ends of the word line or by further providing a current source at a middle portion of the word line.

Therefore, the surplus current which flows in each memory cell can be removed so that no excessive power of the memory cell array is dissipated. Further, the value of a minimum injection current to each cell can be increased as compared with the conventional memory cell array, so that the design margin of the action of the memory cell array can be increased. In addition, as the injection current to each cell is not influenced by the position of the cell, the write and read characteristics of the memory cells can be equalized.

## Claims

1. A semiconductor integrated circuit device for use as a memory cell array including a number of integrated injection logic memory cells, each integrated injection logic memory cell comprising a pair of first ($Q_1$) and second ($Q_2$) transistors of a first conduction type which have a common emitter forming an injector, a pair of third ($Q_3$) and fourth ($Q_4$) transistors of second conduction type each of which has its collector connected to the collector of the first and second transistors respectively, the injector being connected to a first word line (W+), the third transistor ($Q_3$) having its base connected to the collector of the fourth ($Q_4$) transistor, the fourth transistor ($Q_4$) having its base connected to the collector of the third transistor ($Q_3$), and the first ($Q_1$) and second ($Q_2$) transistors having their bases connected to the emitters of the third ($Q_3$) and fourth ($Q_4$) transistors and to a second word line (W—), the second word line being formed by a layer buried in the semiconductor bulk, the semiconductor integrated circuit device being characterised by two current sources ($Q_7$, $Q_8$) one of the current sources ($Q_7$) being connected to one end of the second word line (W—) and the other of the current sources ($Q_8$) being connected to the other end of the second word line (W—).

2. A semiconductor integrated circuit device according to claim 1, further characterised in that a pair of fifth ($Q_5$) and sixth ($Q_6$) transistors of the second conduction type have their bases connected to the bases of the third ($Q_3$) and fourth ($Q_4$) transistors respectively and have their collectors connected to the second word line (W—), the fifth ($Q_5$) and sixth ($Q_6$) transistors having their emitters connected to first and second bit lines ($B_\phi$, $B_1$), respectively.

3. A semiconductor integrated circuit device according to claim 1 ro 2, further characterised in that at least one further current source ($Q_9$) is connected to the middle second word line (W—).

4. A semiconductor integrated circuit device according to any one of the preceding claims, further characterised in that the current sources are each formed by a transistor ($Q_7$, $Q_8$) the collector of which is connected to the second word line (W—), the emitter of which is, in use, connected to an electrical source, and the base of which is, in use, connected to a source of bias voltage.

5. A semiconductor circuit device according to claim 4, further characterised in that the emitters of all of the transistors forming the current sources are equal in area.

6. A semiconductor integrated circuit device according to any one of claims 1 to 4, further characterised in that the areas of the emitters of the transistors forming the current sources are not equal in area to obtain a uniform distribution of the injection current to each memory cell.

7. A semiconductor integrated circuit device according to claim 6, further characterised in that the emitter area of the transistor forming the current source at the middle portion of the second word line (W— is twice as great as that of the emitters of the transistors forming the current sources at the ends of the second word line (W—).

## Revendications

1. Dispositif à circuit intégré semi-conducteur destiné à être utilisé comme réseau de cellules de mémorisation comportant un certain nombre de cellules de mémorisation à logique à injection intégrées, chaque cellule de mémorisation à logique à injection intégrée comprenant un couple formé d'un premier transistor ($Q_1$) et d'un deuxième transistor ($Q_2$) d'un premier type de conduction qui ont un émetteur commun formant un injecteur, un couple formé d'un troisième transistor ($Q_3$) et d'un quatrième transistor ($Q_4$) d'un deuxième type de conduction dont chacun a son collecteur connecté au collecteur respectif du premier et du deuxième transistor, l'injecteur étant connecté à une première ligne de mot (W+), le troisième transistor ($Q_3$) ayant sa base connectée au collecteur du quatrième transistor ($Q_4$), le quatrième transistor ($Q_4$) ayant sa base connectée au collecteur du troisième transistor ($Q_3$), et les premier et deuxième transistors ($Q_1$, $Q_2$) ayant leurs bases connectées aux émetteurs des troisième et quatrième transistors ($Q_3$, $Q_4$) et à une deuxième ligne de mot (W—), la deuxième de mot étant formée par une couche ensevelie dans le corps semi-conducteur, le dispositif à circuit intégré semi-conducteur étant caractérisé par deux sources de courant ($Q_7$, $Q_8$), l'une des sources de courant ($Q_7$) étant connectée à une première extrémité de la deuxième ligne de mot (W—) et l'autre des sources de courant ($Q_8$) étant connectée à l'autre extrémité de la deuxième ligne de mot (W—).

2. Dispositif à circuit intégré semi-conducteur selon la revendication 1, caractérisé en outre en ce qu'un cinquième transistor ($Q_5$) et un sixième transistor ($Q_6$) du deuxième type de conduction formant un couple ont leurs bases respectivement connectées aux bases du troisième transistor ($Q_3$) et du quatrième transistor ($Q_4$) et ont leurs collecteurs connectés à la deuxième ligne de mot (W—), le cinquième transistor ($Q_5$) et le sixième transistor ($Q_6$) ayant leurs émetteurs connectés respectivement à une première et une deuxième ligne de bit ($B_\phi$, $B_1$).

3. Dispositif à circuit intégré semi-conducteur selon la revendication 1 ou 2, caractérisé en outre en ce qu'au moins une source de courant supplémentaire ($Q_9$) est connectée à la deuxième de mot (W—) moyenne.

4. Dispositif à circuit intégré semi-conducteur selon l'une quelconque des revendications précédentes, caractérisé en outre en ce que les sources de courant sont chacune formées par un transistor ($Q_7$, $Q_8$) dont le collecteur est connectée à la deuxième ligne de mot (W—), dont l'émetteur est, en utilisation, connecté à une source électrique, et dont la base est, en utilisation, connectée à une source de tension de polarisation.

5. Dispositif à circuit semi-conducteur selon la revendication 4, caractérisé en outre en ce que les émetteurs de tous les transistors formant les sources de courant sont d'aires égales.

6. Dispositif à circuit intégré semi-conducteur selon l'une quelconque des revendications 1 à 4, caractérisé en outre en ce que les aires des émetteurs des transistors formant les sources de courant ne sont pas d'aires égales de manière à produire une distribution uniforme du courant d'injection à chaque cellule de mémorisation.

7. Dispositif à circuit intégré semi-conducteur selon la revendication 6, caractérisé en outre en ce que l'aire d'émetteur du transistor formant la source de courant à la partie moyenne de la deuxième ligne de mot (W—) est deux fois plus grande que celles des émetteurs des transistors formant les sources de courant aux extrémités de la deuxième ligne de mot (W—).

## Patentansprüche

1. Integrierte Halbleiterschaltungsanordnung zur Verwendung als Speicherzellenanordnung, mit einer Anzahl von Injektions-Logiksspeicherzellen, welche jeweils einen ersten Transistor ($Q_1$) und einen zweiten Transistor ($Q_2$) von einem ersten Leitungstyp umfassen, welche einen gemeinsamen Emitter haben, der den Injektor bildet, und welche jeweils einen dritten Transistor ($Q_3$) und einen vierten Transistor ($Q_4$) vom zweiten Leitungstyp aufweisen, deren Kollektor mit dem Kollektor des ersten Transistors ($Q_1$) bzw. des zweiten Transistors ($Q_2$) verbunden ist, und bei welcher der Injektor mit einer ersten Wortleitung (W+) verbunden, die Basis des dritten Transistors ($Q_3$) mit dem Kollektor des vierten Transistors ($Q_4$) verbunden, die Basis des vierten Transistors ($Q_4$) mit dem Kollektor des dritten Transistors ($Q_3$) verbunden und die Basen des ersten und des zweiten Transistors ($Q_1$ bzw. $Q_2$) mit den Emittern des dritten ($Q_3$) und des vierten Transistors ($Q_4$) und mit einer zweiten Wortleitung (W—) verbunden sind, welche durch eine Schicht gebildet wird, die von Halbleitermaterial umgeben ist, gekennzeichnet durch zwei Stromquellen ($Q_7$, $Q_8$), von denen die eine Stromquelle ($Q_7$) mit einem Ende der zweiten Wortleitung (W—) und die andere Stromquelle ($Q_8$) mit dem anderen Ende der zweiten Wortleitung (W—) verbunden ist.

2. Integrierte Halbleiterschaltungsanordnung nach Anspruch 1, dadurch gekennzeichnet, daß ein füfter Transistor ($Q_5$) und ein sechster Transistor ($Q_6$) vom zweiten Leitungstyp vorgesehen sind, deren Basen mit den Basen des dritten Transistors ($Q_3$) bzw. des vierten Transistors ($Q_4$) und deren Kollektoren mit der zweiten Wortleitung (W—) verbunden sind, während die Emitter des fünften Transistors ($Q_5$) und des sechsten Transistors ($Q_6$) mit der ersten bzw. mit der zweiten Bitleitung ($B_\phi$, $B_1$) verbunden sind.

3. Integrierte Halbleiterschaltungsanordnung nach Anspruch 1 oder 2, dadurch gekennzeichnet, daß wenigstens eine weitere Stromquelle ($Q_9$) mit der Mitte der zweiten Wortleitung (W—) verbunden ist.

4. Integrierte Halbleiterschaltungsanordnung nach einem der vorhergehenden Ansprüche, dadurch gekennzeichnet, daß die Stromquellen jeweils von einem Transistor ($Q_7$, $Q_8$) gebildet werden, dessen Kollektor mit der zweiten Wortleitung (W—), dessen Emitter, im Betrieb, mit einer elektrischen Quelle, und dessen Basis, im Betrieb, mit einer Vorspannungsquelle verbunden sind.

5. Integrierte Halbleiterschaltungsanordnung nach Anspruch 4, dadurch gekennzeichnet, daß die Emitter aller Transistoren, welche die Stromquellen bilden, gleiche Flächenausdehnung aufweisen.

6. Integrierte Halbleiterschaltungsanordnung nach einem der Ansprüche 1 bis 4, dadurch gekennzeichnet, daß die Flächen der Emitter der Transistoren, welche die Stromquellen bilden, ungleiche Flächenausdehnung aufweisen, um eine gleichmäßige Verteilung des Injectionsstromes in jede Speicherzelle zu erzielen.

7. Integrierte Halbleiterschaltungsanordnung nach Anspruch 6, dadurch gekennzeichnet, daß die Emiterfläche des Transistors, welcher die Spannungsquelle am mittleren Abschnitt der zweiten Wortleitung (W—) bildet, zweimal so groß wie die der Emitter derjenigen Transistoren ist, welche die Stromquellen an den Enden der zweiten Wortleitung (W—) bilden.

Fig. 1A

Fig. 1B

Fig. 1C

Fig. 2

# Fig. 3

# Fig. 4 A

# Fig. 4 B

POSITION WHERE
CURRENT SOURCE
IS CONNECTED

CELL POSITION

# Fig. 5

*Fig. 6*

$Q_7' + Q_8'$

$Q_8'$

$Q_7'$

$I_H$

Cel

CELL POSITION

Cen

$I_H/2$

POSITION WHERE CURRENT SOURCE IS CONNECTED

$I_H/2$

POSITION WHERE CURRENT SOURCE IS CONNECTED

## Fig. 7A

## Fig. 7B

## Fig. 8

# Fig. 9

# Fig. 10 A

# Fig. 10B

## Fig. IIA

## Fig. IIB